# EUROPEAN PATENT APPLICATION

(11) **EP 4 495 299 A1**
(43) Date of publication of application: **22.01.2025**
(21) Application number: 23770147.9
(22) Date of filing: 02.02.2023
(51) Int. Cl.: C30B 25/18, C30B 29/38, H01L 21/205

(54) **SEED SUBSTRATE FOR HIGH CHARACTERISTIC EPITAXIAL GROWTH, METHOD FOR PRODUCING SEED SUBSTRATE FOR HIGH CHARACTERISTIC EPITAXIAL GROWTH, SEMICONDUCTOR SUBSTRATE AND METHOD FOR PRODUCING SEMICONDUCTOR SUBSTRATE**

(30) Priority: 18.03.2022 JP 2022044664
(71) Applicant: SHIN-ETSU CHEMICAL CO., LTD., Tokyo 1000005 (JP)
(72) Inventor: KUBOTA Yoshihiro, Annaka-shi, Gunma 379-0195 (JP); KAWAI Makoto, Annaka-shi, Gunma 379-0195 (JP)
(74) Representative: Vossius & Partner Patentanwälte Rechtsanwälte mbB
(86) International application number: PCT/JP2023/003443
(87) International publication number: WO 2023/176185

(57) **Abstract**

The purpose is to obtain high-quality, inexpensive seed substrates with few crystal defects for epitaxial growth of epitaxial substrates and solid substrates of group III nitrides such as AlN, AlₓGa₁₋ₓN (0<X<1) and GaN.

The seed substrate for epitaxial growth of the present invention has a support substrate, a planarizing layer of 0.5 to 3 µm provided on the top surface of the support substrate, and a seed crystal layer provided on the top surface of the planarizing layer. The support substrate includes a composite ceramic core composed of group III nitride polycrystalline ceramics and at least one nitride or oxide of group III or IV, which is a fiber-shaped single crystal, and an encapsulating layer of 0.05 to 1.5 um that encapsulates the core. The seed crystal layer is a layer of Si <111> single crystals of 0.04 to 1.5 um.

## Description

### TECHNICAL FIELD

The present invention relates to a seed substrate for epitaxial growth of group III nitrides such as aluminum nitride (AlN), aluminum gallium nitride (AlₓGa₁₋ₓN (0<x<1)), and gallium nitride (GaN) with high thermal conductivity, high strength, high dimensional accuracy, low warpage, and few defects, and a method for producing the same. That is, a high-quality, inexpensive seed substrate for epitaxial growth of group III nitrides such as AlN, AlₓGa₁₋ₓN (0<x<1), and GaN with good heat dissipation, high mechanical strength, dimensional accuracy, low warpage, and very few crystal defects and voids, and a method for producing the same, and a semiconductor substrate and method for producing the same using the seed substrate.

### BACKGROUND ART

Group III nitride crystal substrates, such as AlN-based substrates and GaN-based substrates, have a wide band gap and excellent high-frequency characteristics with short wavelength luminescence and high breakdown voltage. Therefore, group III nitride substrates are expected to be applied to devices such as light-emitting diodes (LEDs), lasers, Schottky diodes, power devices, and high-frequency devices. For example, AlN-based crystal substrates are increasingly in demand for AlN and/or AlₓGa₁₋ₓN (0.5<X<1) for light-emitting diodes in the deep ultraviolet region (UVC; 200-280 nm) in place of mercury lamps, for disinfection of ballast water in tankers, and recently for coronavirus removal.

However, at present, these single-crystal substrates of AlN and/or AlₓGa₁₋ₓN (0.5<X<1), for example, as described in Non-Patent Document 1 and Non-Patent Document 2, AlN single crystal substrates are difficult to manufacture by the melt method commonly used for silicon (Si) single crystals or the like because AlN has no melting point. So they are manufactured by the sublimation method (modified Raleigh method) using silicon carbide (SiC) or AlN as seed crystals at 1700 to 2250°C under an N₂ atmosphere. Alternatively, they are made by the hydride vapor phase epitaxy (HVPE) on sapphire substrates or AlN substrates obtained by the sublimation method, as disclosed in Patent Document 1 and Non-Patent Document 3. Since AlN single crystals manufactured by the sublimation method require high temperatures for crystal growth, only small-diameter substrates of 2 to 4 inches in diameter can be obtained at present due to equipment limitations, and they are extremely expensive. The dislocation density of the AlN single crystals obtained by the sublimation method is relatively low, smaller than 10⁵ cm⁻², but on the other hand, the crystals are colored by carbon and metallic impurities derived from charcoal materials such as crucibles and insulation materials and have the disadvantages of low resistivity and low UV transmission. On the other hand, AlN single crystals made by hydride vapor phase epitaxy (HVPE) on sapphire substrates are relatively inexpensive and have little coloration, but the difference in lattice constants between AlN and sapphire results in many defects in the AlN crystal and low resistivity. AlN crystals obtained by HVPE deposition on sublimation method AlN substrates have relatively low dislocation density and fewer defects but low transmittance to deep UV luminescence and low resistivity due to colorant contamination from the underlying AlN substrate. In addition, the expensive sublimation method AlN crystals are used as the base substrate that also serves as seed crystals, which has the disadvantage of being extremely costly.

As mentioned above, AlN is of low quality and high price, and the expected characteristics cannot be obtained when fabricating devices for various applications. In addition, it is difficult to deal with heat generation, dimensional accuracy, and warpage in response to recent demands for higher output and miniaturization, which has hindered the widespread use of these substrates and the expansion of their applications.

As for GaN-based substrates, bulk GaN substrates made by growing GaN crystals in liquid ammonia or Na flux have relatively few defects and are of high quality, but they are extremely expensive because they require high-temperature, high-pressure equipment. In addition, as with AlN substrates grown by the sublimation method described above, the bulk GaN substrate is used as a base substrate that also serves as a seed crystal, making it extremely costly. On the other hand, if heteroepitaxial growth of GaN crystal is performed on sapphire or other substrates using the MOCVD or hydride vapor deposition (HVPE method or THVPE method), which grow crystals in the vapor phase, it is possible in principle to achieve higher crystal quality and larger size. In practice, however, the lattice constants and thermal expansion coefficients between the generated GaN crystals and the underlying sapphire substrate differ greatly, resulting in numerous crystal defects and cracks during production, and high-quality crystals cannot be obtained.

On the other hand, GaN-based crystal substrates are required to have higher high-frequency characteristics and greater breakdown voltage performance with the recent launch of 5G communications and the shift to EVs in automobiles. In addition, GaN crystal substrates, as well as AlN crystal substrates, are required to have higher thermal conductivity, higher mechanical strength, higher dimensional accuracy, and lower warpage due to increased power output, miniaturization, and shift to EVs, and these requirements are increasing as substrates become larger in diameter. Therefore, in recent years, for group III nitride crystal substrates such as AlN-based and GaN-based substrates, in addition to the conventional requirements for reduced defects and lower cost, there are urgent requirements to improve the above-mentioned high thermal conductivity, high strength, high dimensional accuracy, or low warpage. However, at present, GaN-based crystal substrates, like AlN-based substrates, have made little progress in improving on these new requirements.

As one of the solutions to these problems, Patent Document 2 discloses a so-called QST (product name) substrate that is a bonded substrate having a support substrate with an AlN ceramic core and an encapsulating layer that encapsulates the AlN ceramic core with a SiO₂/P-Si/SiO₂/Si3N₄ multilayer film, a planarizing layer such as SiO₂ on the top surface of the support substrate, and a seed crystal layer with Si<111> thin film transferred as a seed crystal on the top surface of the planarizing layer.

However, in the above patent, if the film thickness is not well balanced between each multilayer film that encapsulates the core, or between the encapsulating layer, the planarizing layer, and the seed crystal layer, thermal stress due to the difference in thermal expansion coefficient easily occurs, causing cracks or chips between each layer, or warping or distortion in the support substrate. This causes contamination and various distortions in the Si<111> seed crystal due to impurity diffusion in the AlN ceramic core. As a result, epitaxial growth films often have low characteristics with many crystal defects, thermal conductivity, and dimensional stability are often reduced, and the yield rate of Si <111> thin-film transfer to the support substrate is often reduced. In addition, epitaxial film defects, which are thought to originate from the Si <111> nature of the seed crystal itself, often occur, and simultaneous improvement of these defects has been desired.

The inventors started by thoroughly investigating the relationship between the characteristics of the Si<111> seed crystal and the epitaxial film properties, including the reduction of thermal stress between each layer, and found that the number of oxidation-induced stacking faults (OSF) in the Si<111> seed crystal is extremely important, as well as the reduction of thermal stress between each layer. That is, when the oxidation-induced stacking faults are 10 defects/cm² or less, the subsequent epitaxial film has very few crystal defects, which is excellent, and we have previously filed related patent applications (Patent Application 2021-038731 (filed on March 10, 2021) and Patent Application 2021-098993 (filed on June 14, 2021), which are both unpublished at the time of filing of this application).

However, even with such improvements, the above-mentioned improvements of high thermal conductivity, high dimensional accuracy, high strength, and low warpage, which are indispensable for new and increasingly sophisticated applications, were not sufficient, and further improvements and countermeasures were needed.

Some Group III nitride polycrystalline ceramics have relatively high thermal conductivity, but thermal resistance increases at grain boundaries, such as between polycrystalline grains of the ceramic material or on the fusion bonding surfaces with sintering agents, and is not expected to exceed a certain conductivity. For example, even AlN polycrystalline ceramics, which are said to have high thermal conductivity, are usually considered to have an upper limit of about 170 W/mK. In addition, AlN ceramics have relatively weak mechanical strength (fracture toughness) of up to 3 Mpa-m^{1/2}, which is about half that of Si₃N₄ ceramics. Therefore, the thermal conductivity and mechanical strength required for the recent trend toward higher power output and shift to EVs are insufficient, and the poor dimensional accuracy and poor warpage resulting from the low mechanical strength are also major problems.

As a technique to achieve high thermal conductivity and high strength, the addition of fiber-shaped or whisker-shaped single crystals to polycrystalline ceramics is disclosed in Non-Patent Document 5. However, there are no examples of the use of fiber-shaped or whisker-shaped single crystals in bonded substrates, where nano-level smoothness is essential. This is due to the fact that fiber-shaped or whisker-shaped single crystals added in polycrystalline ceramics appear on the surface and prevent the formation of a smooth surface at the nano-level. Even if attempts are made to forcibly smooth the surface by polishing or other means, rather many fiber or whisker steps will occur, and the surface smoothness of Ra of 0.2 nm or less, which is necessary for bonding, cannot be obtained. Therefore, it has been generally accepted that it is totally inappropriate to introduce fiber-shaped or whisker-shaped single crystals into a bonded substrate.

### PRIOR ART DOCUMENTS

### PATENT DOCUMENTS

Patent Document 1: JP6042545B
Patent Document 2: JP6626607B
Patent Document 3: JP2936916B

### NON-PATENT DOCUMENTS

Non-Patent Document 1: Japanese Journal of Applied Physics; Vol.46, No.17,2007, pp.L389-L391
Non-Patent Document 2: SEI Technical Review; No. 177, pp. 88-91
Non-Patent Document 3: Fujikura Technical Review; No. 119, 2010, Vol. 2, pp. 33-38
Non-Patent Document 4: LEDs Magazine Japan; December 2016, pp. 30-31
Non-Patent Document 5: Tetsu-to-Hagane; Vol. 80 (1994) No. 3, p N91 - p N99

### SUMMARY OF THE INVENTION

### PROBLEMS TO BE SOLVED BY THE INVENTION

The present invention was made in view of the above circumstances, and its object is to obtain a seed substrate for high-performance epitaxy of group III nitrides such as AlN, AlₓGa₁₋ₓN (0<X<1), GaN, or the like, with low crystal defects, high characteristics, high thermal conductivity, high strength, low warpage, even for large diameter substrates, and low cost, and the method of producing the same, and semiconductor substrate and method of producing the same.

### MEANS FOR SOLVING THE PROBLEMS

In order to achieve the above-mentioned object, a seed substrate for epitaxial growth of the present invention has a support substrate, a planarizing layer of 0.5 to 3 um provided on the top surface of the support substrate, and a seed crystal layer provided on the top surface of the planarizing layer. The support substrate includes a composite ceramic core composed of group III nitride polycrystalline ceramics and at least one or more group III or IV nitride or oxide fiber-shaped single crystals, and an encapsulating layer of 0.05 to 1.5 um that encapsulates the core. The seed crystal layer is a layer of Si <111> single crystals of 0.04 to 1.5 µm.

With this configuration, planarization that allows bonding can be achieved. That is, since the fiber-shaped (or whisker-shaped) single crystals added to the core are covered by both the encapsulating layer and the planarizing layer with good affinity, no delamination occurs, and no delamination, cracks, or steps occur in subsequent polishing, making it possible to achieve the surface smoothness of Ra of 0.2 nm or less, which is necessary for bonding. As a result, for example, in one example of AlN ceramics with AlN single-crystal fibers, thermal conductivity and fracture toughness are greatly impred to ~200 W/mK and ~10 Mpa-m^{1/2}, respectively, making it possible to produce epitaxial substrates and devices suitable for automotive applications that have recently become more high power and subject to heavy impact. In addition, the warpage of the support substrate greatly affects the process yield in the bonding of seed substrates during the epitaxial substrate manufacturing process, but since this warpage is greatly improved, the yield rate is significantly improved. As a result, the cost of epitaxial substrates can also be reduced.

In the present invention, in the composite ceramics that constitute the core, the group III nitride polycrystalline ceramics may be AlN ceramics, and the fiber-shaped single crystals may be AlN, Si₃N₄, or Al₂O₃.

In the present invention, the encapsulating layer may include at least a layer of Si₃N₄.

In the present invention, the planarizing layer may be a monolayer film of either SiO₂, silicon oxynitride (SiₓO_{y}N_{z}) and AlAs, or a multilayer film of any combination of these.

In the present invention, the oxidation-induced stacking fault (OSF) of the Si<111> single crystal that forms the seed crystal layer is preferably 10 defects/cm² or less. By suppressing OSF in Si <111> seed crystals to 10 defects/cm² or less, defects during epitaxial deposition can be reduced and subsequent device characteristics can be made better. The number of oxidation-induced stacking faults (OSF) (defects/cm²) can be measured by the evaluation method of Patent Document 3.

In the present invention, the electrical resistivity (at room temperature) of Si <111> that forms the seed crystal layer may be 1 kQ-cm or higher.

In the present invention, a stress adjusting layer may be further provided on the bottom surface of the support substrate if necessary.

In the present invention, the stress adjusting layer has a thermal expansion coefficient that is capable of correcting warpage if the warpage needs to be further corrected after the planarizing layer is provided. The stress adjusting layer 5 may be SiO₂, Si₃N₄, amorphous Si, polycrystalline Si, or the like alone or in combination of these. When considering compatibility with electrostatic chucks as well, the stress adjusting layer is preferably polycrystalline Si formed by a method chosen from sputtering, plasma CVD, and LPCVD methods, at least for the lowest layer of the support substrate. In this case, SiO₂ and/or silicon oxynitride (SiₓO_{y}N_{z}) may be interposed between the encapsulating layer and the polycrystalline Si layer to improve affinity with the encapsulating layer. When polycrystalline Si film is used, polycrystallized amorphous Si by heating, laser, or the like, or polycrystalline Si with improved oxidation resistance by partially nitriding the surface layer may be used. It is preferable to provide a polycrystalline Si film as the bottom layer to increase the adsorption force by the electrostatic chuck. This is because the electrostatic chuck force is larger when the resistivity of the film is low and the distance from the film to the electrostatic chuck electrode is short.

In the present invention, the encapsulating layer may be deposited by the LPCVD.

In the present invention, the planarizing layer may be deposited on one of the top surfaces or the entire surface of the support substrate with AlAs by either plasma CVD, LPCVD, or low-pressure MOCVD.

In the present invention, the seed crystal layer may be provided by ion implanting hydrogen and/or He into Si<111> single crystal with OSF of 10 defects/cm² or less and electrical resistivity (at room temperature) of 1 kS2-cm or more, bonding the Si<111> single crystal to the top surface of the planarizing layer, and then peeling off the surface layer of the Si<111> single crystal by physical means at 450°C or less to perform thin-film transfer.

The semiconductor substrate of an embodiment of the present invention is characterized in that a III-V semiconductor thin film is deposited on the top surface of a seed substrate for epitaxial growth of either of the above. The III-V semiconductor thin film may be a nitride semiconductor thin film containing Ga and/or Al.

The method for producing a seed substrate for epitaxial growth according to an embodiment of the present invention comprises the steps of: preparing the composite ceramic core composed of a polycrystalline ceramics of group III nitrides and at least one nitride or oxide of group III or IV, which is a fiber-shaped single crystal; obtaining a supporting substrate by depositing an encapsulating layer so as to wrap the core, the encapsulating layer having a thickness of between 0.05 µm and 1.5 µm, inclusive; depositing a planarizing layer on an upper surface of the supporting substrate, the planarizing layer having a thickness of between 0.5 um and 3.0 um, inclusive; and providing a seed crystal layer with a thickness of 0.04 to 1.5 um by thin-film transfer of Si <111> single crystal on the top surface of the planarizing layer.

In the present invention, the encapsulating layer may be deposited by the LPCVD.

In the present invention, the planarizing layer may be made of SiO₂ and/or silicon oxynitride (SiₓO_{y}N_{z}) or AlAs on one of the top surfaces or the entire surface of the support substrate by either plasma CVD, LPCVD or low pressure MOCVD.

In the present invention, in the step of providing the seed crystal layer, the seed crystal layer may be provided by ion implanting hydrogen and/or He into Si<111> single crystal with OSF of 10 defects/cm² or less and an electrical resistivity (at room temperature) of 1 kS2-cm or more, bonding the Si<111> single crystal to the top surface of the planarizing layer, and peeling off the surface layer of the Si<111> single crystal by physical means at 450°C or less to perform thin-film transfer.

In the present invention, in the step of providing the seed crystal layer, the seed crystal layer may be provided by ion implanting hydrogen and/or He into Si<111> single crystal with oxidation-induced stacking faults of 10 defects/cm² or less, followed by thin-film transfer of 0.20 to 1.7 um of the surface layer of Si<111> single crystal by physical means at 450°C or less, and adjusting the thickness to 0.04 to 1.5 µm.

In the present invention, in the step of providing the seed crystal layer, the seed crystal layer may be provided by ion implanting hydrogen and/or He into Si<111> single crystal with oxidation-induced stacking faults of 10 defects/cm² or less, followed by thin-film transfer of 0.20 to 1.7 um of the surface layer of Si<111> single crystal by physical means at 450°C or less, and adjusting the thickness to 0.04 to 1.5 µm.

In the present invention, in the step of providing the seed crystal layer, the thickness of the seed crystal layer may be adjusted to 0.04 to 1.5 um by CMP polishing and/or etching with a chemical solution on the thin-film transferred Si <111> single crystal.

The present invention may further comprise a step of further providing a stress adjusting layer on the bottom surface of the support substrate. This stress adjusting layer may have a thermal expansion coefficient that enables further correction of the warpage after the planarizing layer is provided, and may consist of polycrystalline Si prepared by a method selected from at least the sputtering, plasma CVD and LPCVD and/or polycrystalline Si whose surface layer is partially nitrided in a nitrogen atmosphere.

The method for producing a semiconductor substrate according to an embodiment of the present invention comprises the steps of: manufacturing a seed substrate for epitaxial growth by any of the above methods; and depositing a III-V semiconductor thin film on the top surface of the seed substrate for epitaxial growth.

### EFFECT OF THE INVENTION

The present invention can provide seed substrates for epitaxial use and semiconductor substrates using the seed substrates, which are superior in terms of crystal defects, high thermal conductivity, high strength, low warpage, and low cost.

### BRIEF DESCRIPTION OF THE DRAWINGS

FIG. 1 is a diagram showing the cross-sectional structure of a seed substrate 1.
FIG. 2 is a diagram showing the procedure for manufacturing the seed substrate 1.

### EMBODIMENTS OF THE INVENTION

The embodiments of the present invention will be described in detail hereinafter, but the present invention is not limited thereto.

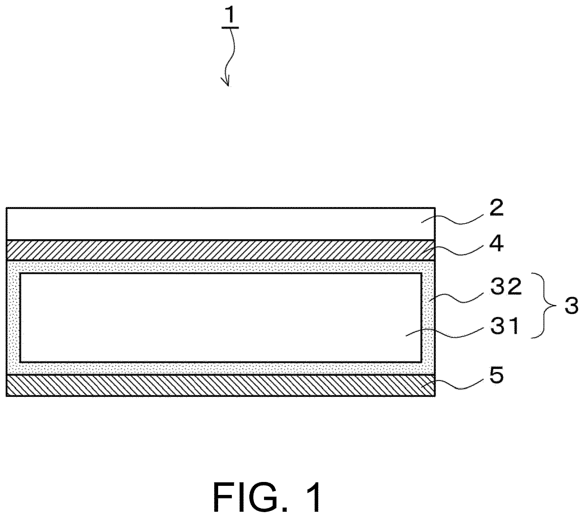

FIG. 1 shows a cross-sectional structure of a seed substrate for epitaxial growth of group III nitrides (hereinafter simply referred to as "seed substrate") 1. The seed substrate 1 shown in FIG. 1 has a structure in which a planarizing layer 4 and a Si <111> seed crystal layer 2 are stacked on a support substrate 3. In addition, if necessary, the stress adjusting layer 5 is provided on the surface (bottom surface) of the support substrate 3 opposite the surface on which the planarizing layer 4 is stacked.

The support substrate 3 has a core 31 serving as the core material of the support substrate 3, and an encapsulating layer 32 covering the core 31.

The core 31 is a composite ceramics comprising polycrystalline ceramic powder of group III nitrides, sintering agents, or the like, and at least one or more nitrides or oxides of group III or IV that are fiber-shaped single crystals. It is suitable that the composite ceramics are made by sintering polycrystalline ceramic powder materials (e.g., AlN, Si₃N₄, GaN, or a mixture of these), nitrides or oxides of group III or Iv that are fiber-shaped single crystals (e.g., AlN, Si₃N₄ or Al₂O₃ singly or in a mixture), and sintering agents ( e.g., Y₂O₃, Al₂O₃, CaO, or the like).

AlN composite ceramics is the most suitable as a support substrate for epitaxial growth of group III nitride crystals, which is the purpose of this invention, because lattice constant and thermal expansion coefficient thereof are close to those of epitaxial films, it has the best thermal conductivity, and relatively inexpensive raw materials can be used. The composite ceramics is usually mixed with polycrystalline AlN powder, fiber-shaped AlN single crystals, Y₂O₃ and the like, and then may be sintered directly in a hot press machine at 1750-2000°C in an N₂ atmosphere. Alternatively, a slurry may be made of polycrystalline AlN powder, fiber-shaped AlN single crystals, Y₂O₃ or the like, polymers such as poval and methyl cellulose, plasticizers such as polyethylene glycol, and solvents such as water, then formed into sheets using doctor blades or the like, degreased in a degreasing furnace, and then sintered in a sintering furnace. The hot press machine is generally used when characteristics are prioritized, while the sheet molding/atmospheric pressure sintering method is generally chosen when cost is prioritized.

In more detail, to further improve the thermal conductivity, mechanical strength, and warpage of AlN ceramics consisting of polycrystalline AlN powder and sintering agents, fiber-shaped single crystals of nitrides or oxides of Group III or Group IV may be added to polycrystalline AlN powder to form composite ceramics. The fiber-shaped single crystals to be added may be selected from AlN, Si₃N₄, or Al₂O₃, which have high thermal conductivity, high aspect ratio, the same or relatively close thermal expansion coefficient to that of the AlN powder matrix, and affinity with the AlN powder, as well as electrical insulation properties.

The thermal conductivities of AlN, Si₃N₄, or Al₂O₃ fiber-shaped single crystals are roughly 270-300 W/mK, 100-140 W/mK, and 20-45 W/mK, respectively, which are relatively high, but the values vary widely. Because of their large aspect ratio, the addition of these fiber-shaped single crystals improves mechanical strength and, along with that, suppresses thermal expansion and warpage of the substrate. The order of their mechanical strength is usually Si₃N₄ < Al₂O₃ < AlN, and the price is Al₂O₃ < Si₃N₄ < AlN. Therefore, the choice should be made among the above three materials, either individually or in combination, taking into consideration the characteristics suitable for the application and economical efficiency. The example introduced individually is shown below.

If extremely high thermal conductivity is required and not so much mechanical strength is needed, fiber-shaped single crystals of AlN may be selected. On the contrary, if the thermal conductivity is moderate but impact resistance is required, such as for automotive applications, fiber-shaped Si₃N₄ single-crystals may be selected. If cost is a priority and only moderately high thermal conductivity and mechanical strength are required, fiber-shaped Al₂O₃ single-crystals may be selected.

The mixing ratio of fiber-shaped single crystal in composite ceramics is chosen taking into considerations of cost effectiveness, but it should be in the range of 5-50 wt%. If the mixing ratio is less than 5%, the effect of characteristic improvement is small, and if the mixing ratio exceeds 50%, the effect tends to saturate and the cost effectiveness is low. The epitaxial substrates of the present invention need to be placed on the semiconductor production line in subsequent device processing. Therefore, after sintering and fabricating into wafer shape, the sintered material is preferably ground and polished to a substrate thickness of 200 to 1000 µm, and then CMP polishing is performed to further improve smoothness, resulting in a mirror finish.

The present invention is based on the above composite ceramic core being collectively encapsulated with an encapsulating layer of 0.05 to 1.5 um of the present invention, especially a layer containing at least a layer of Si₃N₄, as a support substrate, and further covered with a planarizing layer of 0.5 to 3 um on the top surface of said support substrate, so that fiber-shaped or whisker- shaped single crystals are blended with the AlN powder of the matrix, and after complete integration by the stacking effect of the two layers, flatness of Ra = 0.2 nm or less, which can be bonded, is obtained by polishing. In other words, by optimizing the composition and thickness of the above two layers, which are essential components of the invention, flatness that allows bonding can be obtained only when the synergistic effect of the two is realized. In the present invention, the planarizing layer may be a monolayer film of either SiO₂, silicon oxynitride and AlAs, or a multilayer film of any combination of these (e.g., stacked SiO₂ and silicon oxynitride or stacked SiO₂ and AlAs).

If only the composite ceramics prepared as described above is used as the core 31 as it is, raw materials such as AlN powder and fiber-shaped single crystal, metallic impurities in the sintering binders, such as Y₂O₃ powder, and carbon, oxygen, and other impurities from insulation materials, furnace materials, containers, or the like during sintering will result in many crystal defects and coloration in the target epitaxial single crystal, and adverse effects occur.

Therefore, the encapsulating layer 32 is provided that wraps and encapsulates the composite ceramic core 31. Specifically, when encapsulating the core 31 with the encapsulating layer 32, each layer constituting the encapsulating layer 32 must be considered in terms of its composition and thickness so that thermal stress is as small as possible and thermal conduction is as large as possible. In the present invention, it is preferable to optimize the total thickness of the encapsulating layer 32 in the range of 0.05 to 1.5 µm from the viewpoint of characteristics and manufacturing cost.

The composition of the encapsulating layer 32 can be selected appropriately in consideration of thermal expansion coefficient and thermal conductivity, but to enhance its impurity diffusion prevention ability, it is preferable to cover and encapsulate the entire core at least with a film consisting of silicon nitride (Si₃N₄).

This encapsulating layer 32 may be provided with p-Si as a layer for electrostatic chucking if necessary, for example, if the use of electrostatic chucking is desired. This p-Si layer may be deposited between the composite ceramic core and the Si₃N₄ layer, or together with or under the stress adjusting layer 5 described below. In such cases, if adhesion between p-Si and Si₃N₄ is insufficient, a film of SiO₂ or silicon oxynitride (SiₓO_{y}N_{z}) with high adhesion properties may be interposed, taking into account the affinity and thermal expansion coefficient between each layer. Furthermore, p-Si may be partially nitrided polycrystalline Si to prevent oxidation of p-Si.

For the seed substrate for epitaxial growth of group III nitride such as GaN for high frequency applications, especially for very high frequency applications such as giga Hz wave or millimeter wave, in order to avoid high frequency losses in devices fabricated using epitaxial layers grown on the seed substrates, the electrical resistivity (room temperature) of the above Si <111> seed crystal layer 2 is preferably 1 kS2-cm or more. This is because the Si <111> seed crystal layer 2 with electrical resistivity (at room temperature) of 1 kQ-cm or less would cause high-frequency losses due to giga Hz wave or millimeter wave, resulting in device heat generation and high power consumption, and would not provide required characteristics.

When a p-Si film is provided for the electrostatic chuck, p-Si with higher resistance is preferred within the range where the required adsorption force can be obtained. The p-Si film may be deposited on the lower layer of core 31, as far away as possible from the seed crystal layer 2 on which the epitaxial film is stacked, or on the lower part of the stress adjusting layer 5. Alternatively, the p-Si film may be multi-layered deposited simultaneously with the stress adjusting layer 5. High-resistance p-Si has low high-frequency loss. When the high-resistance p-Si is placed at the bottom of the support substrate 3, it is close to the electrostatic chuck, so even with high resistance, sufficient electrostatic force is available. Therefore, substrate adsorption is possible sufficiently without doping. To further reduce high-frequency losses, it is more desirable to remove the p-Si layer by back-grinding the substrate at the end of device fabrication. When the stress adjusting layer 5 is provided, it is preferable to maintain the p-Si resistance as high as possible, but the minimum amount of boron (B), phosphorus (P), or other doping necessary to generate the required electrostatic force is not restricted.

In the encapsulating layer 32, if the thickness of each layer becomes too thick, the stress between the layers increases due to the difference in thermal expansion coefficient, causing delamination between the layers. Therefore, even if films of various compositions are selected and combined, it is not desirable for the thickness of the encapsulating layer 32 to be more than 1.5 µm. On the other hand, in terms of the function of sealing impurities, a thickness less than 0.05 um is insufficient to prevent the diffusion of impurities. From the above, the thickness of the encapsulating layer 32 is preferably in the range of 0.05 to 1.5 µm. The deposition method of the encapsulating layer can be selected from MOCVD, atmospheric pressure CVD, LPCVD, sputtering, or the like. The LPCVD is particularly preferred because of the film quality, the film coverage, and the impurity diffusion prevention ability.

A planarizing layer 4 of 0.5 to 3 um is stacked on the encapsulating layer 32 at least on the top surface of the support substrate 3. The planarizing layer 4 is selected from ceramic film materials such as SiO₂, Al₂O₃, Si₃N₄, SiC, silicon oxynitride (SiₓO_{y}N_{z}), or the like, or Si, GaAs, AlAs, or the like, which are often used as sacrificial layers for etching or the like. It is preferable to select SiO₂ and/or silicon oxynitride (SiₓO_{y}N_{z}) or AlAs, which are easy to grind or polish during planarization and easy to separate when obtaining solid substrates.

The planarizing layer 4 is normally stacked only on one side on the encapsulating layer 32 from a cost standpoint, but if warpage is large, it can be deposited to cover the entire encapsulating layer 32. The thickness of the planarizing layer 4 must be thick enough to sufficiently fill the voids and irregularities in the composite ceramic core 31 with the encapsulating layer 32, or the steps created by the fiber-shaped single crystal mentioned above, and also smooth enough to allow the seed crystal to be transferred. However, a planarizing layer 4 that is too thick is undesirable, because even if the composite ceramic core contains fiber-shaped single crystals, the thermal stress in the thick planarizing layer is not fully suppressed, causing warpage, cracks, or the like in the seed substrate 1. Therefore, it is suitable to provide a planarizing layer with a thickness of 0.5 to 3 um on at least the top surface of the support substrate. If the thickness is less than 0.5 µm, it is difficult for the encapsulating layer 32 and the planarizing layer 4 to fill the voids and irregularities in the composite ceramic core 31 or the steps caused by fiber-shaped single crystals. On the other hand, if the thickness is 3 µm or thicker, warpage and cracks caused by the planarizing layer 4 are likely to occur.

Plasma CVD, LPCVD, or low-pressure MOCVD are suitable for the deposition of the planarizing layer 4 in terms of its required film quality and deposition efficiency. The stacked planarizing layer 4 is heat treated for vitrification and CMP polished for planarization, depending on the film conditions, to prepare for thin-film transfer of the seed crystal layer 2 described below.

The seed crystal layer 2 is provided by thin-film transfer of the seed crystal on the surface of the planarizing layer 4. The seed crystal used for thin film transfer is selected to be a substrate with a crystal structure similar to group III nitrides such as AlN, AlₓGa₁₋ₓN (0<X<1), GaN, or the like, which are the subject of the present invention. Therefore, AlN, Si<111>, SiC, SCAM, AlN, AlGaN, sapphire, or the like are candidates, but Si<111> is suitable from the viewpoints of ease of large-diameter production, availability of mass-produced commercial products, and low cost. Si<111> single crystals with oxidation-induced stacking faults (OSF) of 10 defects/cm² or less are particularly suitable.

When the OSF of Si<111> single crystal, which is the seed for the subsequent process of epitaxial deposition, is 10 defects/cm² or less, the epitaxially deposited crystal has fewer defects following the seed crystal, resulting in superior device characteristics and high yield, which leads to low cost. On the other hand, when the OSF exceeds 10 defects/cm², defects in the epitaxially deposited crystal increase greatly, resulting in poor device characteristics, which inevitably worsen yield and lead to high costs.

If the electrical resistivity (at room temperature) of the Si <111> seed crystal is less than 1 kQ-cm, its resistance causes high-frequency loss, which increases power consumption and generates heat, degrading device characteristics. When the epitaxial substrates and solid substrates obtained by epitaxial deposition on the seed substrates 1 are used for high-frequency devices, especially for 5G and beyond, it is preferable to select Si <111> single crystals with electrical resistivity (room temperature) of 1 kS2-cm or higher.

The Si<111> seed crystal is ion implanted only with hydrogen and/or helium (He) ion species that have little effect on the electrical resistance of the single crystal substrate, and then the ion-implanted surface of the Si <111> seed crystal is bonded to the top surface of the planarizing layer 4, and the Si <111> seed crystal is peeled off using physical means such as nails at 450°C or lower. Thereby, the surface layer of the Si <111> single crystal is separated at the ion implantation depth, and a thin film of the Si <111> is transferred to the planarizing layer 4. This means that the seed crystal layer 2 is provided on the top surface of the planarizing layer 4. Unlike heavy elements such as boron (B), light elements such as hydrogen and He are suitable for ion implantation into seed crystals because ion implantation causes little damage to the seed crystal and does not lower its electrical resistance. In addition, peeling and transferring at low temperatures below 450°C prevents thermal damage to the Si<111> single crystal, which is unavoidable in the smart-cut method of thermal peeling and transferring at high temperatures above 700°C.

The final thickness of the seed crystal layer 2 is preferably between 0.04 um and 1.5 µm, inclusive. In the ion implantation, the ion damage layer alone has a thickness of nearly 0.1 um, and a suitable seed crystal cannot be obtained if the thickness is less than 0.04 um. In addition, the ion implant machine requires high output ion energy for transfer thicknesses of 1.5 um or more, and the ion implanter becomes huge in size, requiring a huge investment, which is not economical. To provide the seed crystal layer 2 of appropriate thickness, the surface layer of 0.20 to 1.7 µm of Si <111> single crystal may be transferred as a thin film and then the thickness may be adjusted to 0.04 to 1.5 um. The thickness of the Si <111> single-crystal thin film to be transferred has a lower limit defined by the margin for removing the damaged layer during ion implantation, and an upper limit defined by the limitations of the ion implantation equipment (larger equipment and higher cost due to high acceleration voltage). The range can be 0.1 to 2.0 µm, but 0.20 to 1.7 µm is more preferable. Adjustment of thickness may be performed by CMP polishing and/or etching with a chemical solution.

To be more specific, after ion implanting hydrogen and/or He into the seed crystal to a depth of 0.2 to 1.7 um, the top surface of the planarizing layer 4 and the ion implanted surface of the seed crystal are bonded. Then, the seed crystal may be peeled off by gas pressure, a nail, or other physical methods at temperatures below 450°C. By setting the processing temperature below 450°C, stress and thermal damage due to impurity diffusion and thermal stress, which can easily occur in the seed crystals of the transferred thin film due to processing at high temperatures above 450°C, can be suppressed.

The top surface of the transferred thin film may then be CMP polished and/or lightly etched with a chemical solution to remove the ion implantation damage layer to obtain a seed single-crystal thin film (seed crystal layer) with a thickness of 0.04 to 1.5 um. If higher uniformity is required for ion implantation, SiO₂ or the like can be deposited on the ion implantation surface of the seed substrate before ion implantation, if necessary.

In the present invention, a stress adjusting layer 5 may be further added to the bottom surface of the support substrate 3, depending on the circumstances. The stress adjusting layer 5 corrects the warpage of the seed substrate 1 caused by forming the planarizing layer 4. For the stress adjusting layer 5, film material and thickness with a thermal expansion coefficient that enables correction of warpage of the seed substrate 1 are selected. It is suitable to deposit at least polycrystalline Si (p-Si) as the stress adjusting layer 5, which is also compatible with the electrostatic chuck. SiO₂ and/or silicon oxynitride (SiₓO_{y}N_{z}) or the like as a part of the stress reduction layer may be interposed between the polycrystalline Si constituting the stress adjusting layer 5 and the encapsulating layer 32 from the viewpoint of warpage correction and affinity with the encapsulating layer 32. Furthermore, the polycrystalline Si may be partially nitrided to provide oxidation resistance.

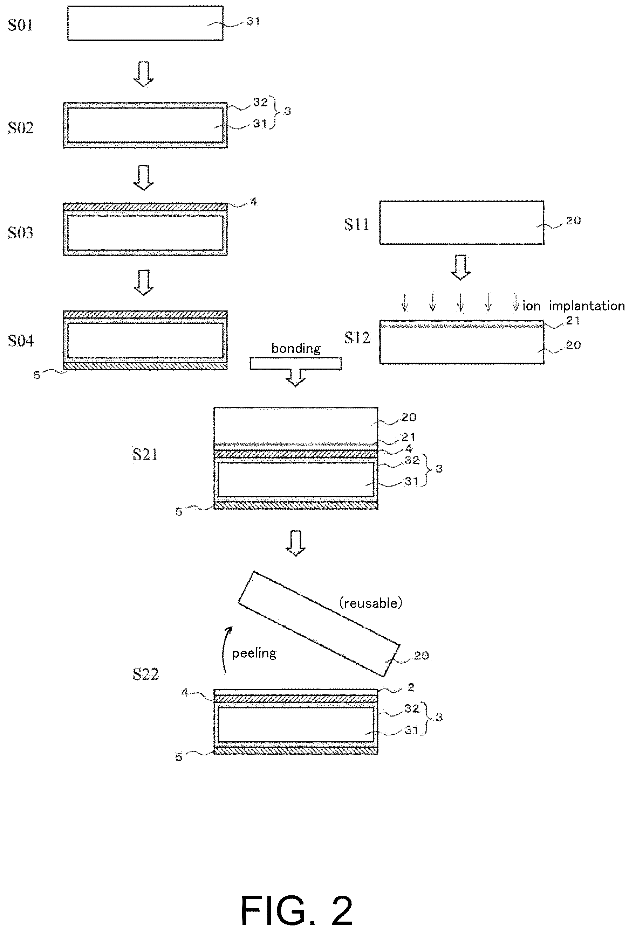

Then, with reference to FIG. 2, the procedure for manufacturing method of the seed substrate for group III nitride epitaxial growth according to the embodiment of the present invention will be described. If a suitable method for forming each layer has already been described in conjunction with the composition of each part of the seed substrate 1, a redundant explanation here is omitted.

First, the composite ceramic core 31, composed of a polycrystalline ceramics of group III nitrides, and at least one nitride or oxide of group III or IV, which is a fiber-shaped single crystal, is prepared (S01 in Fig. 2). Next, the encapsulating layer 32 with a thickness of between 0.05 um and 1.5 µm, inclusive, is deposited so as to wrap in the core 31 and the support substrate 3 is obtained (S02 in FIG. 2). In this case, the encapsulating layer 32 may be deposited by using an LPCVD. Next, the planarizing layer 4 with a thickness of between 0.5 µm and 3.0 um, inclusive, is deposited on the upper surface of the support substrate 3 (S03 in FIG. 2). If necessary, the stress adjusting layer 5 is deposited on the bottom surface of the support substrate 3 (S04 in FIG. 2). As the stress adjusting layer 5, it is preferable to form a film of SiO₂, Si₃N₄, amorphous Si, polycrystalline Si, or the like alone or a combination of these films to correct the warpage after the planarizing layer 4 is provided. However, when considering electrostatic chuck compatibility, it is preferable to directly form at least polycrystalline Si on the bottom layer of the support substrate 3 by any of the sputtering, plasma CVD, or LPCVD methods. Alternatively, when it is difficult to bond the bottom of the support substrate 3 to this polycrystalline Si, it is preferable to form a polycrystalline Si layer at the bottom of the support substrate 3 after forming bulk SiO₂ and/or silicon oxynitride (SiₓO_{y}N_{z}) at the bottom. The polycrystalline Si can be polycrystalline Si itself, or polycrystallized amorphous Si by heating, lasers, or the like. The polycrystalline Si can be polycrystalline Si with the surface layer partially nitrided to improve oxidation resistance. Or, the polycrystalline Si can be partially nitrided or a Si₃N₄ film can be further attached after the polycrystalline Si film is deposited to further improve oxidation resistance. The planarizing layer 4 and the stress adjusting layer 5 may be deposited at the same time.

Apart from S01-S04, a Si <111> single-crystal substrate 20, which is a seed crystal for peeling transfer of the seed crystal layer 2, is prepared (S11 in FIG. 2) . Next, ion implantation is performed from one surface (ion implantation surface) of the single crystal substrate 20, and a peeling position (embrittlement layer) 21 is formed in the single crystal substrate 20 (S12 in FIG. 2).

Next, the ion implantation surface of the single crystal substrate 20 is bonded to the planarizing layer 4 formed on the support substrate 3 to obtain a bonded substrate (S21 in FIG. 2). If necessary, the bonded substrate may be heated to 450°C or less to increase bonding strength. Then, the single crystal substrate 20 is separated at the peeling position 21 of the single crystal substrate 20 in the bonded substrate (S22 in FIG. 2). In this way, a single crystal film of Si <111> is thinly transferred as a seed crystal layer 2 onto the planarizing layer 4 on the support substrate 3. The thickness of the transferred seed crystal layer 2 is adjusted by CMP polishing and/or etching with a chemical solution as needed. On the other hand, the remaining section of the separated Si <111> single crystal substrate 20 can be repeatedly utilized for transferring a seed crystal layer when fabricating another group III nitride composite substrate by polishing the surface again to make an ion implantation surface.

As described above for the composition and manufacturing method of the seed substrate 1 for epitaxial growth, the seed substrate 1 for epitaxial growth has a support substrate, a 0.5 to 3 um of planarizing layer provided on the top surface of the support substrate, and a seed crystal layer provided on the top surface of the planarizing layer. The support substrate includes a composite ceramic core composed of group III nitride polycrystalline ceramics and at least one nitride or oxide of group III or IV, which is a fiber-shaped single crystal, and an encapsulating layer of 0.05 to 1.5 um that encapsulates the core. The seed crystal layer of 0.04 to 1.5 µm is provided by thin-film transfer of the surface layer of Si <111> single crystal with oxidation-induced stacking faults of 10 defects/cm² or less. According to the present invention, in particular, high thermal conductivity, high strength, high dimensional accuracy, and low warpage due to the effect of adding fiber-shaped single crystals are realized by the following features 1) to 3), and as additional effects, a high characteristic and low cost epitaxial film crystal substrate can be obtained. 1) Using the composite ceramic core composed of a polycrystalline ceramics of group III nitrides and at least one nitride or oxide of group III or IV, which is a fiber-shaped single crystal. 2) Minimizing thermal stress by optimizing the composition and thickness of the planarizing layer, seed crystal layer, and other layers, as well as the support substrate. 3) Providing the seed crystal layer by thin-film transfer of the surface layer of Si <111> single crystal with oxidation-induced stacking faults of 10 defects/cm² or less.

These effects of the present invention are the result not only of individual factors, but also of the successful expression of a "synergistic effect" in which each factor complements the other. Other additional factors such as 4) further stress reduction with a stress adjusting layer if necessary, and 5) thin film transfer by ion implantation limited to light elements of hydrogen and/or He and peeling off by physical means such as nails at 450°C or lower also contribute to the realization of the effect of the present invention.

The substrate of this invention significantly improves the characteristics of devices, such as light-emitting diodes used in the deep ultraviolet region (UVC; 200-280nm) and devices with increasingly higher output, higher frequency, and higher breakdown voltage as their applications expand to 5G communications and EV vehicles, and also significantly improves device manufacturing yields, thereby enabling lower cost.

### EXAMPLES

The present invention will be described more specifically hereinafter by citing examples and comparative examples below, but the present invention is not limited to these examples.

### [Example 1]

### (Preparation of Support Substrate)

The following material was prepared as a support substrate 3 with a structure consisting of a core 31 of composite ceramics consisting of polycrystalline ceramics of group III nitrides and fiber- shaped single crystals of group III nitrides, covered with an encapsulating layer 32. That is, for the core 31 of composite ceramics, a green sheet was made by mixing commercially available AlN powder, 80wt%, commercially available AlN fiber-shaped single crystal, 20wt%, and commercially available Y₂O₃ as a sintering agent, 5wt%, with organic binders and solvents, and after degreasing, sintered at 1900°C under an N₂ atmosphere. The sintered body was then formed into an 8-inch diameter wafer shape and polished on both sides to produce a composite ceramic core with a substrate of 8 inches in diameter × 725 µm in thickness. After polishing the AlN composite ceramic core substrate, the Ra of its surface was measured, and some stepped areas in the form of fiber-shaped single crystals were observed. Ra, which indicates flatness, was measured, and the result was Ra = 520 nm (0.52 um) on average of 10 points. The entire AlN composite ceramic core 31 was covered with a silicon oxynitride layer of 0.1 µm thick by LPCVD, and then the entire core was encapsulated with a Si₃N₄ layer of 0.4 µm thick using a different LPCVD system to form the encapsulating layer 32. The total thickness of the encapsulating layer 32 was 0.5 um. For the purpose of planarization, a 6 um thick SiO₂ was further stacked on the Si₃N₄ layer only on one of top layer by using the plasma CVD (ICP-CVD apparatus). Then, after baking at 1000°C, the SiO₂ was polished to a thickness of 2 um by CMP polishing, and Ra, which represents the degree of flatness, was measured, and the result was Ra = 0.18 nm on average of 10 points. The flatness was confirmed to be sufficient for bonding and prepared for thin-film transfer of the seed crystal in the subsequent process.

### (Preparation of Seed Crystal)

A Si <111> single-crystal substrate of 8 inches in diameter and 725 um in thickness was prepared as the seed crystal substrate. This Si<111> single-crystal substrate had oxidation-induced stacking faults (OSF) of 9 defects/cm² and electrical resistivity (room temperature) of 1.2 kS2-cm by the evaluation method described in Patent Document 3. Ion implantation of hydrogen was carried out on the Si substrate at 100 keV, at a depth of 0.6um, and with a dose of 8 × 10¹⁷ cm⁻².

A thin film transfer of the 0.6 µm surface layer of this ion-implanted Si <111> single crystal was attempted onto the planarizing layer 4 (2 um thickness) of the previously prepared support substrate 3. Even composite ceramic cores containing AlN fiber-shaped single crystals could successfully transfer Si <111> of the seed crystal. The portion of the Si <111> single crystal, which was damaged during ion implantation and transfer, was lightly polished with CMP, and the Si <111> single crystal layer was made into a seed crystal layer 2 of 0.3 um thick. The resulting seed substrate 1 was free of cracks, delamination, and warpage as a result of ensuring that the film thicknesses were balanced with respect to the thermal stresses between each layer of the encapsulating layer 32, the encapsulating layer 32, the planarizing layer 4, and the seed crystal layer 2.

The remaining Si<111> single-crystal substrate after thin-film transfer can be used repeatedly as many seed crystals by repeated ion implantation, which was extremely economical.

The following recipes and methods were used to conduct a brief evaluation of the characteristics of this seed substrate 1 as a seed substrate for the epitaxial growth of GaN.

Epitaxial growth on the above seed substrate 1 was performed in an MOCVD apparatus. In this process, the epitaxial layers were deposited in the order of AlN and AlGaN from the seed substrate 1 side toward the growth direction, followed by the epitaxial growth of GaN. For this epitaxial deposition, the AlN and AlGaN layers were formed 110 nm and 140 nm, respectively, and the GaN epitaxial layer thickness was 5 um. During epitaxial growth, TMAl (trimethylaluminum) was used as the Al source, TMGa (trimethylgallium) was used as the Ga source, and NH3 was used as the N source. The carrier gases were N₂ and H₂, and the process temperatures ranged from 900 (prev. stage) to 1200°C (GaN deposition).

The thermal conductivity, fracture toughness as mechanical strength, and WARP as warpage evaluation of the above epitaxial substrates were measured to be 230 W/mK, 9 Mpa m^{1/2}, and 22 um, respectively. Then, to evaluate dislocation density, etch pits were generated by a molten alkali (KOH) etching method, and etch pit density (EPD) was measured. In addition, X-ray rocking curve (XRC) measurement was performed to evaluate the crystallinity.

As a result, the EPD showed an extremely low dislocation density of 0.1 × 10⁴ cm⁻². The XRC measurements on a (0002) plane of the substrate yielded a half-value width FWHM (hereafter simply referred to as "FWHM of 0002XRC") of 128 arcsec, resulting in a high-quality GaN single crystal. These results show that the seed substrate 1 in this example has excellent characteristics as a seed substrate for epitaxial growth. When this epitaxial substrate with an epitaxial layer on the seed substrate 1 was used for a 30 GHz/20 Gbps high-frequency device, the surface temperature of the device was 45°C, and there was no temperature increase due to high-frequency loss that would cause a problem.

### [Comparative Example 1]

The conditions were the same as in Example 1, including the evaluation method, except that the support substrate was made of commercially available AlN powder (100wt%) and and commercially available Y₂O₃ (5wt%) as a sintering agent, and Si <111> single-crystal substrate as the seed crystal substrate had an oxidation-induced stacking fault (OSF) of 15 defects/cm² and electrical resistivity (room temperature) of 0.7 kQ-cm, and this Si <111> single-crystal substrate was thinly transferred as the seed crystal layer 2 with a thickness of 1.7 µm.

In the same manner as the Example 1, the thermal conductivity, fracture toughness as mechanical strength, and WARP as warpage evaluation of the epitaxial substrates were measured to be 150 W/mK, 3 Mpa-m^{1/2}, and 55 µm, respectively. Then, to evaluate dislocation density, etch pits were generated by a molten alkali (KOH) etching method, and EPD was measured. In addition, XRC measurements were performed to evaluate the crystallinity. As a result, the EPD showed an extremely large dislocation density of 10 × 10⁴ cm⁻². In addition, the FWHM of the 0002 XRC was 920 arcsec, resulting in a GaN single crystal with poor crystallinity compared to Example 1. When this epitaxial substrate was used for high-frequency devices at 30 GHz/20 Gbps, the surface temperature of the device reached 132°C due to high-frequency loss, thus requiring water cooling for long-term use.

### [Example 2]

The conditions were the same as in Example 1, including the evaluation method, except that the support substrate was made of commercially available AlN powder, 80wt%, commercially available Si₃N₄ fiber-shaped single crystal, 30wt%, and commercially available Y₂O₃ 5wt% and Al₂O₃, 2wt% as sintering agent.

In the same manner as the Example 1, the thermal conductivity, fracture toughness as mechanical strength, and WARP as warpage evaluation of the epitaxial substrates were measured to be 175 W/mK, 15 Mpa-m^{1/2}, and 7 um, respectively and WARP was extremely small. Then, to evaluate dislocation density, etch pits were generated by a molten alkali (KOH) etching method, and EPD was measured. In addition, XRC measurements were performed to evaluate the crystallinity. As a result, the EPD showed a relatively small dislocation density of 0.6 × 10⁴ cm⁻². In addition, the FWHM of the 0002 XRC was 320 arcsec, resulting in slightly worse crystallinity compared to Example 1. When this epitaxial substrate was used for high-frequency devices at 30 GHz/20 Gbps, the surface temperature of the device reached 78°C due to high-frequency loss, and long-term use was possible with air cooling only.

### REFERENCE SIGNS LIST

1 Seed substrate
2 Seed crystal layer
3 Support substrate
4 Planarizing layer
5 Stress adjusting layer
20 Single crystal substrate of seed crystal
21 Peeling position

## Claims

1. A seed substrate for epitaxial growth compring:
a support substrate;
a planarizing layer provided on an upper surface of the support substrate, the planarizing layer having a thickness of between 0.5 µm and 3.0 um, inclusive; and
a seed crystal layer provided on an upper surface planarizing layer,
wherein the support substrate comprises:
a composite ceramic core composed of polycrystalline ceramics of group III nitrides and at least one nitrides or oxides of Group III or IV, which is a fiber-shaped single crystal; and
an encapsulating layer that encapsulates the core, the encapsulating layer having a thickness of between 0.05 um and 1.5 µm, inclusive, and
wherein the seed crystal layer is a layer of Si <111> single crystal of 0.04 to 1.5 um.

2. The seed substrate for epitaxial growth as claimed in claim 1, wherein the group III nitride polycrystalline ceramics forming the core are AlN ceramics and the fiber-shaped single crystals are AlN, Si₃N₄ or Al₂O₃.

3. The seed substrate for epitaxial growth as claimed in claim 1 or 2, wherein the the encapsulating layer includes at least a layer of Si₃N₄.

4. The seed substrate for epitaxial growth as claimed in any one of claims 1 to 3, wherein the planarizing layer is a monolayer film of either SiO₂, silicon oxynitride (SiₓO_{y}N_{z}) and AlAs, or a multilayer film of any combination of these.

5. The seed substrate for epitaxial growth as claimed in any one of claims 1 to 4, wherein the oxidation-induced stacking faults in Si <111> single crystal that forms the seed crystal layer are 10 defects/cm² or less.

6. The seed substrate for epitaxial growth as claimed in any one of claims 1 to 5, wherein the electrical resistivity (at room temperature) of Si <111> single crystal forming the seed crystal layer is 1 kS2-cm or higher.

7. The seed substrate for epitaxial growth as claimed in any one of claims 1 to 6, further comprises a stress adjusting layer on the bottom surface of the support substrate.

8. The seed substrate for epitaxial growth as claimed in claim 7, wherein the stress adjusting layer has a thermal expansion coefficient that enables further correction of the warpage after the planarizing layer is provided, and consists of polycrystalline Si prepared by a method selected from at least the sputtering, plasma CVD, and LPCVD.

9. The seed substrate for epitaxial growth as claimed in claim 7 or 8, wherein the stress adjusting layer is composed of polycrystalline Si provided immediately below the lower surface of the support substrate interposed by SiO₂ and/or silicon oxynitride (SiₓO_{y}N_{z}), and/or polycrystalline Si whose surface layer is partially nitrided.

10. The seed substrate for epitaxial growth as claimed in any one of claims 1 to 9, wherein the encapsulating layer is deposited by LPCVD.

11. The seed substrate for epitaxial growth as claimed in any one of claims 1 to 10, wherein the planarizing layer is formed by depositing SiO₂ and/or silicon oxynitride (SiₓO_{y}N_{z}) or AlAs on one of the top surfaces or the entire surface of the support substrate by one of plasma CVD, LPCVD, and lowpressure MOCVD.

12. The seed substrate for epitaxial growth as claimed in any one of claims 1 to 11, wherein the seed crystal layer is provided by ion implanting hydrogen and/or He into Si<111> single crystal with oxidation-induced stacking faults of 10 defects/cm² or less and electrical resistivity (at room temperature) of 1 kQ-cm or more, followed by peeling off the surface layer of the Si<111> single crystal by physical means at 450°C or less to perform thin-film transfer.

13. A semiconductor substrate on which a III-V semiconductor thin film is deposited on the top surface of a seed substrate for epitaxial growth according to any one of claims 1 to 12.

14. The semiconductor substrate as claimed in claim 13, wherein wherein the III-V semiconductor thin film is a nitride semiconductor thin film containing Ga and/or Al.

15. A method for producing seed substrate for epitaxial growth comprising steps of:
preparing the composite ceramic core composed of a polycrystalline ceramics of group III nitrides and at least one nitride or oxide of group III or IV, which is a fiber-shaped single crystal;
obtaining a supporting substrate by depositing an encapsulating layer so as to wrap the core, the encapsulating layer having a thickness of between 0.05 µm and 1.5 µm, inclusive;
depositing a planarizing layer on an upper surface of the support substrate, the planarizing layer having a thickness of between 0.5 µm and 3.0 µm, inclusive; and
providing a seed crystal layer with a thickness of 0.04 to 1.5 um by thin-film transfer of Si <111> single crystal on the top surface of the planarizing layer.

16. The method for producing seed substrate for epitaxial growth as claimed in claim 15, wherein the encapsulating layer is deposited by the LPCVD.

17. The method for producing seed substrate for epitaxial growth as claimed in claim 15 or 16, wherein the planarizing layer is formed by depositing SiO₂ and/or silicon oxynitride (SiₓO_{y}N_{z}) or AlAs on one of the top surfaces or the entire surface of the support substrate by one of plasma CVD, LPCVD, and low-pressure MOCVD.

18. The method for producing seed substrate for epitaxial growth as claimed in any one of claims 15 to 17, wherein in the step of providing the seed crystal layer, the seed crystal layer is provided by ion implanting hydrogen and/or He into Si<111> single crystal with oxidation-induced stacking faults of 10 defects/cm² or less and electrical resistivity (at room temperature) of 1 kQ-cm or more, bonding the Si<111> single crystal to the top surface of the planarizing layer, and then peeling off the surface layer of Si<111> single crystal by physical means at 450°C or less to perform thin-film transfer.

19. The method for producing seed substrate for epitaxial growth as claimed in any one of claims 15 to 18, wherein in the step of providing the seed crystal layer, the seed crystal layer is provided by ion implanting hydrogen and/or He into Si<111> single crystal with oxidation-induced stacking faults of 10 defects/cm² or less, followed by thin-film transfer of 0.20 to 1.7 um of the surface layer of Si<111> single crystal by physical means at 450°C or less, and adjusting the thickness to 0.04 to 1.5 um.

20. The method for producing seed substrate for epitaxial growth as claimed in any one of claims 15 to 18, wherein in the step of providing the seed crystal layer, the seed crystal layer is provided by ion implanting hydrogen and/or He into Si<111> single crystal with oxidation-induced stacking faults of 10 defects/cm² or less and electrical resistivity (at room temperature) of 1 kQ-cm or more, followed by thin-film transfer of 0.20 to 1.7 µm of the surface layer of Si<111> single crystal by physical means at 450°C or less, and adjusting the thickness to 0.04 to 1.5 µm.

21. The method for producing seed substrate for epitaxial growth as claimed in claim 19 or 20, wherein in the step of providing the seed crystal layer, the thickness of the seed crystal layer is adjusted to 0.04 to 1.5 µm by CMP polishing and/or etching with a chemical solution on the thin-film transferred Si <111> single crystal.

22. The method for producing seed substrate for epitaxial growth as claimed in any one of claims 15 to 21, further providing a stress adjusting layer on the bottom surface of the support substrate.

23. The method for producing seed substrate for epitaxial growth as claimed in claim 22, wherein the stress adjusting layer has a thermal expansion coefficient that enables further correction of the warpage after the planarizing layer is provided, and consists of polycrystalline Si prepared by a method selected from at least the sputtering, plasma CVD, and LPCVD method and/or polycrystalline Si whose surface layer is partially nitrided in a nitriding atmosphere.

24. A method for producing semiconductor substrate comprising steps of:
producing a seed substrate for epitaxial growth by the method for producing a seed substrate for epitaxial growth as claimed in any one of claims 15 to 23; and
depositing a III-V group semiconductor thin film on the top surface of the seed substrate for epitaxial growth.
